# EUROPEAN PATENT APPLICATION

(11) **EP 4 620 616 A1**
(43) Date of publication of application: **24.09.2025**
(21) Application number: 25162141.3
(22) Date of filing: 06.03.2025
(51) Int. Cl.: B24B 9/06, B24B 21/08

(54) **POLISHING APPARATUS, POLISHING METHOD, AND POLISHING HEAD**

(30) Priority: 08.03.2024 JP 2024035634; 12.02.2025 JP 2025020467
(71) Applicant: EBARA CORPORATION, Ota-ku, Tokyo 144-8510 (JP)
(72) Inventor: UCHIYAMA, Keisuke, Tokyo, 1448510 (JP); KODERA, Kenji, Tokyo, 1448510 (JP)
(74) Representative: Pritzlaff, Stefanie Lydia

(57) **Abstract**

A polishing apparatus capable of removing a chipping is disclosed. The polishing apparatus includes a first polishing head and a second polishing head. The first polishing head is configured to press a first polishing tool against a peripheral portion of a substrate to form a recess in the peripheral portion. The second polishing head is configured to press a second polishing tool against a polishing boundary of the recess.

## Description

### BACKGROUND OF THE INVENTION

### Field of the Invention:

The present invention relates to a polishing apparatus, a polishing method, and a polishing head.

### Description of the Related Art:

In recent years, in order to achieve higher density and higher functionality in semiconductor devices, development of three-dimensional packaging technology has been progressing, in which a plurality of substrates are stacked to integrate them three-dimensionally. In the three-dimensional packaging technology, for example, a device surface of a first substrate on which an integrated circuit and electrical wiring are formed is bonded to a device surface of a second substrate on which an integrated circuit and electrical wiring are formed.

After a first substrate is bonded to a second substrate, the first substrate is thinned by a polishing apparatus or a grinding apparatus. In this manner, integrated circuits can be stacked in a direction perpendicular to the device surface of the first substrate and the second substrate. In this specification, a form of a plurality of substrates bonded to each other may be referred to as "a laminated substrate" or "a composite substrate."

### Citation List

### Patent Literature

Patent document 1: Japanese laid-open patent publication No. 2021-037585
Patent document 2: Japanese laid-open patent publication No. 2022-037426

Normally, a peripheral portion of the substrate is pre-polished to a rounded shape, and grinding the first substrate having such a rounded peripheral portion results in a sharp end portion (knife edge portion) being formed in the first substrate.

Such a knife edge portion is easily chipped by physical contact. Furthermore, the knife edge portion may cause damage to the laminated substrate itself during transporting the laminated substrate. In order to prevent a formation of the knife edge portion, a polishing tool (e.g., a polishing tape) is pressed against the peripheral portion of the laminated substrate while rotating the laminated substrate, removing the peripheral portion of the first substrate and forming a recess in the peripheral portion of the laminated substrate.

However, forming such a recess may result in the formation of a chip, called chipping, at a polishing boundary of the recess, which may cause defects in the laminated substrate and therefore must be removed.

Such a problem is not necessarily limited to the laminated substrate (i.e., composite substrate). For example, even in a single substrate that is not the laminated substrate, chipping may occur at the polishing boundary of the recess due to the formation of the recess. Therefore, even in a single substrate, it is necessary to remove chipping.

### SUMMARY OF THE INVENTION

Therefore, the present invention provides a polishing apparatus, a polishing method, and a polishing head capable of removing the chipping.

In an embodiment, there is provided a polishing apparatus comprising: a first polishing head configured to hold a first polishing tool having a first angle as an acute angle; and a second polishing head configured to hold a second polishing tool having a second angle as a right angle or an obtuse angle, and the first polishing head is configured to press the first polishing tool against a peripheral portion of a substrate to form a recess in the peripheral portion, and the second polishing head is configured to press the second polishing tool against a polishing boundary of the recess.

In an embodiment, the first polishing head corresponds to a rough polishing head configured to press a rough polishing tape as the first polishing tool against the peripheral portion to form a recess in the peripheral portion, the second polishing head corresponds to a finish polishing head configured to press a finish polishing tape as the second polishing tool against the polishing boundary, the rough polishing head is configured to support the rough polishing tape so that a tape angle of the rough polishing tape is the first angle, and the finish polishing head is configured to support the finish polishing tape so that a tape angle of the finish polishing tape is the second angle.

In an embodiment, each of the rough polishing head and the finish polishing head comprises: a pressing member for pressing each of the rough polishing tape and the finish polishing tape against the peripheral portion, an immediately preceding guide roller disposed upstream of the pressing member in a conveying direction of each of the rough polishing tape and the finish polishing tape, and disposed adjacent to the pressing member, and an immediately preceding guide roller actuator configured to move the immediately preceding guide roller.

In an embodiment, the immediately preceding guide roller actuator is configured to move the immediately preceding guide roller in a direction approaching the pressing member and in a direction away from the pressing member.

In an embodiment, the polishing apparatus comprises an operation controller configured to control an operation of the immediately preceding guide roller actuator, and the operation controller is configured to: operate the immediately preceding guide roller actuator to move the immediately preceding guide roller until the tape angle of the rough polishing tape becomes the first angle; and operate the immediately preceding guide roller actuator to move the immediately preceding guide roller until the tape angle of the finish polishing tape becomes the second angle.

In an embodiment, the operation controller is configured to: operate the immediately preceding guide roller actuator to move the rough polishing tape in a depth direction of the substrate while the tape angle is at the first angle, forming the recess having a predetermined depth in the peripheral portion; and operate the immediately preceding guide roller actuator to set the tape angle to the second angle and press the finish polishing tape against the polishing boundary.

In an embodiment, the operation controller is configured to operate the immediately preceding guide roller actuator to press the finish polishing tape in an area located between the immediately preceding guide roller and the pressing member against the polishing boundary.

In an embodiment, each of the rough polishing head and the finish polishing head comprises: a preceding guide roller disposed upstream of the immediately preceding guide roller in the conveying direction of each of the rough polishing tape and the finish polishing tape, and disposed adjacent to the immediately preceding guide roller; and a preceding guide roller actuator configured to move the preceding guide roller, and the preceding guide roller actuator is configured to move the preceding guide roller until the preceding guide roller reaches a third angle greater than the second angle.

In an embodiment, the polishing apparatus comprises an operation controller configured to control an operation of the preceding guide roller actuator, and the operation controller is configured to operate the immediately preceding guide roller actuator to press the finish polishing tape against the polishing boundary, and operate the preceding guide roller actuator to move the preceding guide roller until the tape angle becomes the third angle.

In an embodiment, the first polishing head is configured to hold a first grindstone as the first polishing tool, the second polishing head is configured to hold a second grindstone as the second polishing tool, the first grindstone has a tapered recess configured to form the first angle, and the second grindstone has a tapered protrusion configured to form the second angle.

In an embodiment, there is provided a polishing method comprising: pressing a first polishing tool having a first angle as an acute angle against a peripheral portion of a substrate by a first polishing head to form a recess in the peripheral portion; and pressing a second polishing tool having a second angle as a right angle or obtuse angle against a polishing boundary of the recess by a second polishing head.

In an embodiment, the first polishing head corresponds to a rough polishing head configured to press a rough polishing tape as the first polishing tool against the peripheral portion to form a recess in the peripheral portion, the second polishing head corresponds to a finish polishing head configured to press a finish polishing tape as the second polishing tool against the polishing boundary, and the polishing method comprising: setting a tape angle of the rough polishing tape to the first angle, and pressing the rough polishing tape against the peripheral portion to form the recess in the peripheral portion; and setting a tape angle of the finish polishing tape to the second angle, and pressing the finish polishing tape against the polishing boundary.

In an embodiment, comprising: operating an immediately preceding guide roller disposed upstream of a pressing member in a conveying direction of each of the rough polishing tape and the finish polishing tape and disposed adjacent to the pressing member to set the tape angle to the first angle; and operating the immediately preceding guide roller to set the tape angle to the second angle.

In an embodiment, comprising operating a preceding guide roller disposed upstream of the immediately preceding guide roller in the conveying direction of each of the rough polishing tape and the finish polishing tape and disposed adjacent to the immediately preceding guide roller to set the tape angle to a third angle greater than the second angle.

In an embodiment, the first polishing head is configured to hold a first grindstone as the first polishing tool, the second polishing head is configured to hold a second grindstone as the second polishing tool, and the polishing method comprising: pressing the first grindstone having a tapered recess configure to form the first angle against the peripheral portion to form the recess in the peripheral portion; and pressing the second grindstone having a tapered protrusion configured to form the second angle against the polishing boundary.

In an embodiment, there is provided a polishing head comprising: a pressing member for pressing a polishing tape against a peripheral portion; an immediately preceding guide roller disposed upstream of the pressing member in a conveying direction of the polishing tape and disposed adjacent to the pressing member; and an immediately preceding guide roller actuator configured to move the immediately preceding guide roller, and the immediately preceding guide roller actuator is configured to: move the immediately preceding guide roller until a tape angle of the polishing tape becomes a first angle as an acute angle; and move the immediately preceding guide roller until the tape angle becomes a second angle as a right angle or an obtuse angle.

In an embodiment, the immediately preceding guide roller actuator is configured to move the immediately preceding guide roller in a direction approaching the pressing member and in a direction away from the pressing member.

In an embodiment, the polishing head is configured to: move the polishing tape in a depth direction of the substrate to form a recess having a predetermined depth in the peripheral portion while setting the tape angle to the first angle by the immediately preceding guide roller actuator; and press the polishing tape against a polishing boundary of the recess while setting the tape angle to a second angle by the immediately preceding guide roller actuator.

In an embodiment, the polishing head comprises: a preceding guide roller disposed upstream of the immediately preceding guide roller in a conveying direction of the polishing tape and disposed adjacent to the immediately preceding guide roller; and a preceding guide roller actuator configured to move the preceding guide roller, and the preceding guide roller actuator is configured to move the preceding guide roller until the tape angle becomes a third angle greater than the second angle.

According to the above method, the polishing apparatus can remove chipping.

### BRIEF DESCRIPTION OF THE DRAWINGS

FIG. 1 is a side view showing a peripheral portion of a composite substrate to be polished;
FIG. 2 is a view showing an embodiment of a polishing apparatus;
FIGS. 3A and 3B are views showing an immediately preceding guide roller actuator that moves an immediately preceding guide roller;
FIGS. 4A and 4B are views showing a preceding guide roller actuator that moves a preceding guide roller;
FIGS. 5A to 5D are views showing steps of polishing a first wafer;
FIG. 6 is a view showing a flow of polishing the first wafer by the polishing apparatus;
FIG. 7 is a view showing a polishing boundary of a recess;
FIG. 8 is a view showing a polishing head that removes a chipping with a polishing tape;
FIG. 9 is a view showing another embodiment of the polishing apparatus;
FIG. 10A is a view showing another embodiment of the polishing apparatus;
FIG. 10B is a view showing another embodiment of the polishing apparatus;
FIG. 10C is a view showing a pressing member having a first angle;
FIG. 10D is a view showing a pressing member having a second angle;
FIG. 11 is a view showing another embodiment of the polishing apparatus;
FIG. 12A is a view showing a grindstone having a tapered recess, and FIG. 12B is a view showing a grindstone having a tapered protrusion;
FIGS. 13A to 13C are views showing a process of polishing the peripheral portion of the wafer; and
FIGS. 14A and 14B are views showing a manufacturing process of the composite wafer.

### DESCRIPTION OF EMBODIMENTS

Hereinafter, embodiments of the present invention will be described with reference to the drawings. In the drawings described below, the same or corresponding components are denoted by the same reference numerals, and duplicated descriptions will be omitted. In the multiple embodiments described below, configuration of one embodiment that is not particularly described is the same as other embodiments, and duplicated descriptions will be omitted.

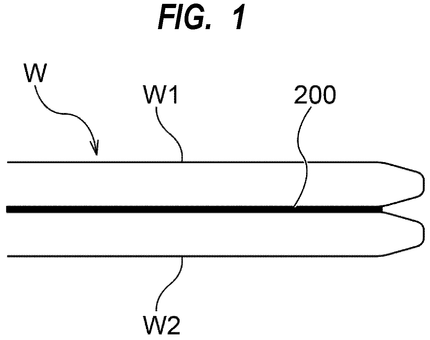

FIG. 1 is a side view showing a peripheral portion of a composite substrate to be polished. As shown in FIG. 1, the composite substrate W has a structure in which a first substrate W1 and a second substrate W2 are superimposed. The first substrate W1 is a device substrate (or device wafer) having a device layer 200 on which a circuit pattern or the like is formed.

The second substrate W2 is a support substrate (or a support wafer) for supporting the first substrate W1. The device layer 200 faces the second substrate W2. The first substrate W1 and the second substrate W2 are bonded together with or without an adhesive.

A circular wafer is an example of a substrate, and the substrate to be polished in the present invention is not limited to a circular wafer. In the embodiment described below, a wafer is used as an example of a substrate. Therefore, in the following description, the composite substrate W is referred to as a composite wafer W, the first substrate W1 is referred to as a first wafer W1, and the second substrate W2 is referred to as a second wafer W2, but it is not intended that the present invention be limited to the embodiment described below.

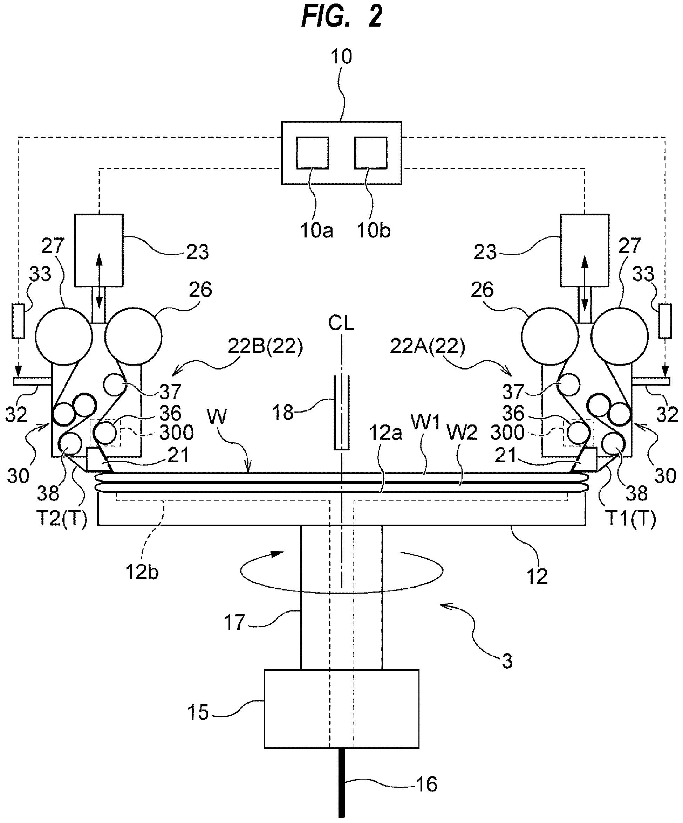

FIG. 2 is a view showing an embodiment of a polishing apparatus. As shown in FIG. 2, the polishing apparatus includes a substrate holding device 3 configured to hold and rotate the composite wafer W, a first polishing head 22A and a second polishing head 22B configured to polish the peripheral portion of the first wafer W1 to form the recess in the peripheral portion of the composite wafer W, and an operation controller 10 that controls operations of the substrate holding device 3 and the polishing heads 22A and 22B.

The substrate holding device 3 includes a holding stage 12 having a substrate holding surface 12a for holding the composite wafer W, a stage rotation device 15 for rotating the holding stage 12 around an axis CL of the substrate holding surface 12a, and a stage shaft 17 fixed to a lower portion of the holding stage 12.

The holding stage 12 has an opening 12b, such as a hole or a groove, formed in the substrate holding surface 12a. The opening 12b is connected to a vacuum line 16. The holding stage 12 may have a plurality of openings 12b. When a vacuum is formed in the opening 12b through the vacuum line 16 with the composite wafer W placed on the substrate holding surface 12a, the composite wafer W is held to the substrate holding surface 12a by the vacuum.

The substrate holding surface 12a has the same contour shape as the composite wafer W. In this embodiment, the composite wafer W is circular, and the substrate holding surface 12a is also circular. The substrate holding surface 12a has the same size as the composite wafer W. That is, a diameter of the substrate holding surface 12a is the same as the diameter of the composite wafer W. Therefore, an entire lower surface of the composite wafer W is held by the substrate holding surface 12a.

In one embodiment, the substrate holding surface 12a may be smaller than the composite wafer W, as long as it is capable of supporting the peripheral portion of the composite wafer W. In one embodiment, the substrate holding surface 12a may be larger than the composite wafer W.

The stage rotation device 15 includes an electric motor and is coupled to a stage shaft 17. When the stage rotation device 15 is driven, the holding stage 12 and the stage shaft 17 rotate together about the axis CL of the substrate holding surface 12a.

The composite wafer W is held on the substrate holding surface 12a so that an axis of the composite wafer W coincides with the axis CL of the substrate holding surface 12a. Therefore, the composite wafer W rotates integrally with the holding stage 12 around the axis of the composite wafer W (i.e., the axis CL of the substrate holding surface 12a).

The polishing apparatus includes a liquid supply nozzle 18 disposed above the substrate holding surface 12a. The liquid supply nozzle 18 is connected to a liquid supply line (not shown) and is configured to supply a liquid such as pure water or functional water to the center of the composite wafer W.

The functional water is an acidic liquid, an alkaline liquid, ozone water, fine bubble water, etc, containing water. The liquid supplied to the center of the rotating composite wafer W spreads over the entire upper surface of the composite wafer W by centrifugal force, washing away polishing debris.

Each of the polishing heads 22A, 22B includes a pressing member 21 for pressing each of polishing tapes T1, T2, which are examples of polishing tools, against the peripheral portion of the composite wafer W on the substrate holding surface 12a, and a moving actuator 23 for moving the pressing member 21 in a direction perpendicular to the substrate holding surface 12a.

In this embodiment, the polishing head 22A is a rough polishing head that supports a rough polishing tape T1 having abrasive grains on its surface. The polishing head 22B is a finish polishing head that supports a finish polishing tape T2 having abrasive grains on its surface that are smaller in diameter than the abrasive grains of the rough polishing tape T1. Hereinafter, in this specification, the rough polishing tape T1 and the finish polishing tape T2 may be simply referred to as the polishing tape T without any particular distinction.

In this embodiment, the first polishing head 22A and the second polishing head 22B have the same configuration. Therefore, in this specification, the polishing heads 22A and 22B may be simply referred to as the polishing head 22 without being differentiated from each other.

The polishing head 22 is disposed above an outer periphery of the substrate holding surface 12a. The moving actuator 23 is held by a holding member such as a bracket (not shown). A specific configuration of the moving actuator 23 is not particularly limited, but an example of the moving actuator 23 is an air cylinder or a combination of a ball screw mechanism and a servo motor.

The polishing head 22 includes a supply reel 26 that supplies the polishing tape T, a take-up reel 27 that takes up the polishing tape T, and a tape feed mechanism 30 that feeds the polishing tape T in its longitudinal direction (i.e., the conveying direction). The moving actuator 23 is configured to move the supply reel 26, the take-up reel 27, the pressing member 21, and the tape feed mechanism 30 together.

The pressing member 21 is disposed above the outer periphery of the substrate holding surface 12a. The pressing member 21 is located directly above the peripheral portion of the composite wafer W held on the substrate holding surface 12a. The pressing member 21 supports a back side of the polishing tape T and presses a polishing surface (front side) of the polishing tape T against the peripheral portion of the composite wafer W, thereby polishing the peripheral portion of the first wafer W1.

The moving actuator 23 moves the pressing member 21 toward the peripheral portion of the composite wafer W. By this movement, the pressing member 21 can press the polishing tape T against the peripheral portion of the first wafer W1.

A force (i.e., a polishing load) with which the pressing member 21 presses the polishing tape T against the peripheral portion of the first wafer W1 can be adjusted by the moving actuator 23. The polishing tape T at a polishing point of the composite wafer W extends in a radial direction of the composite wafer W (i.e., a radial direction of the substrate holding surface 12a).

As shown in FIG. 2, the polishing head 22 includes a sensor target 32, and a displacement sensor 33 disposed facing the sensor target 32. The sensor target 32 can be moved integrally with the pressing member 21 by the moving actuator 23.

The displacement sensor 33 is configured to detect a movement distance of the sensor target 32, i.e., the movement distance of the pressing member 21. An example of the displacement sensor 33 include a contact type displacement sensor or a non-contact type displacement sensor.

The displacement sensor 33 is electrically connected to the operation controller 10. The displacement sensor 33 detects a signal corresponding to the movement distance of the pressing member 21 during polishing of the peripheral portion of the first wafer W1. The movement distance of the pressing member 21 is the movement distance from an initial position of the pressing member 21 in a direction perpendicular to the substrate holding surface 12a. In one example, the initial position may be a position of the pressing member 21 when the pressing member 21 brings the polishing tape T into contact with an upper surface of the first wafer W1 while the composite wafer W is not rotating.

The operation controller 10 includes a storage device 10a in which a program is stored, and a processing device 10b that executes operations according to instructions included in the program. The processing device 10b includes a CPU (Central Processing Unit) or a GPU (Graphics Processing Unit) that executes operations according to instructions included in the program stored in the storage device 10a.

The storage device 10a includes a main storage device (e.g., a random access memory) accessible by the processing device 10b, and an auxiliary storage device (e.g., a hard disk drive or a solid state drive) for storing data and programs. The operation controller 10 includes at least one computer.

The displacement sensor 33 is configured to send a signal corresponding to the moving distance of the pressing member 21 to the operation controller 10. The operation controller 10 is configured to measure the moving distance of the pressing member 21 based on the signal sent from the displacement sensor 33, and to determine a polishing end point of the first wafer W1 based on the measured moving distance. In this embodiment, the moving distance of the pressing member 21 corresponds to the moving distance of the polishing head 22.

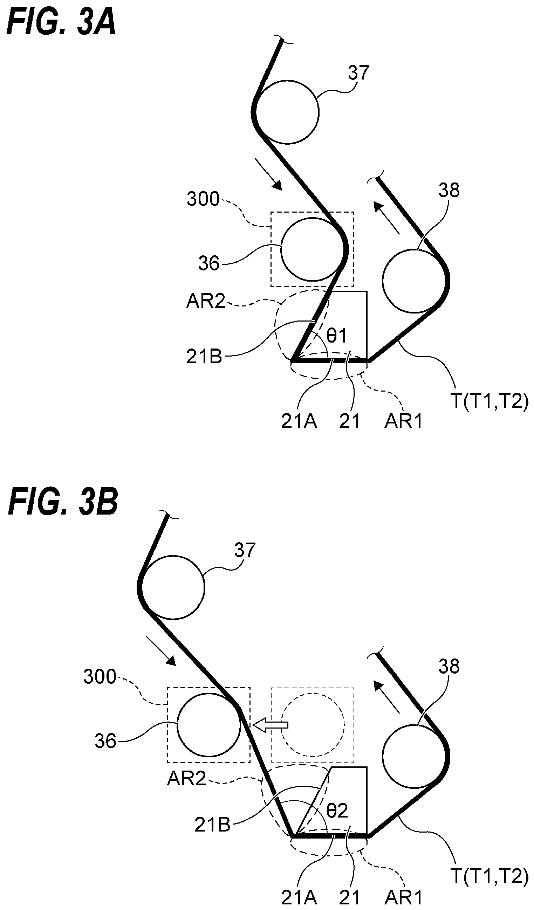

FIGS. 3A and 3B are views showing an immediately preceding guide roller actuator that moves an immediately preceding guide roller. The polishing head 22 includes an immediately preceding guide roller 36 disposed upstream of the pressing member 21 in the conveying direction of the polishing tape T and disposed adjacent to the pressing member 21, and an immediately preceding guide roller actuator 300 that moves the immediately preceding guide roller 36.

The immediately preceding guide roller 36 is configured to support the polishing tape T being transported from the supply reel 26 to the take-up reel 27. The pressing member 21 has a pressing surface 21A parallel to the substrate holding surface 12a and an inclined surface 21B connected to the pressing surface 21A. The pressing surface 21A forms a bottom surface of the pressing member 21. The inclined surface 21B faces the axis CL of the substrate holding surface 12a and forms an inner surface of the pressing member 21.

The immediately preceding guide roller 36 determines a relative position of the polishing tape T with respect to the inclined surface 21B of the pressing member 21. The immediately preceding guide roller actuator 300 is configured to move the immediately preceding guide roller 36 until a tape angle of the polishing tape T becomes a first angle θ1, and to move the immediately preceding guide roller 36 until the tape angle becomes a second angle θ2.

The tape angle is defined as an angle formed by the polishing tape T in an area AR1 facing the pressing surface 21A and the polishing tape T in an area AR2 facing the inclined surface 21B. The area AR2 corresponds to an area located between the immediately preceding guide roller 36 and the inclined surface 21B of the pressing member 21.

In this embodiment, the first angle θ1 is an acute angle, and the second angle θ2 is an obtuse angle. In one embodiment, the second angle θ2 may be a right angle. That is, the second angle θ2 is a right angle or an obtuse angle.

A combination of a ball screw mechanism and a servo motor is one example of the immediately preceding guide roller actuator 300. For example, the immediately preceding guide roller 36 is coupled to a ball screw mechanism (not shown) and configured to be movable by driving of a servo motor (not shown).

The operation controller 10 is electrically connected to the immediately preceding guide roller actuator 300, and is configured to control an operation of the immediately preceding guide roller actuator 300. The operation controller 10 operates the immediately preceding guide roller actuator 300 to move the immediately preceding guide roller 36 in the horizontal direction (i.e., the direction parallel to the substrate holding surface 12a).

When the immediately preceding guide roller actuator 300 moves the immediately preceding guide roller 36 in a direction approaching the pressing member 21 (i.e., the approaching direction), the immediately preceding guide roller 36 moves the polishing tape T and determines the tape angle to the first angle θ1 (see FIG. 3A).

When the immediately preceding guide roller actuator 300 moves the immediately preceding guide roller 36 in a direction away from the pressing member 21 (i.e., in a moving away direction), the immediately preceding guide roller 36 moves the polishing tape T and determines the tape angle to be the second angle θ2 (see FIG. 3B). In this embodiment, the second angle θ2 is an angle within a range of approximately 100 to 110 degrees.

The polishing head 22 includes an immediately following guide roller 38 disposed downstream of the pressing member 21 in the conveying direction of the polishing tape T. The tape feed mechanism 30 is disposed downstream of the immediately following guide roller 38 (see FIG. 2).

The tape feed mechanism 30 is configured to feed the polishing tape T at a predetermined speed from the supply reel 26 to the take-up reel 27 during polishing of the composite wafer W. In one embodiment, the polishing head 22 does not necessarily have to include the tape feed mechanism 30, and may be configured to feed the polishing tape T by a tension motor (not shown) coupled to the take-up reel 27.

The polishing head 22 is disposed upstream of the immediately preceding guide roller 36 in the conveying direction of the polishing tape T, and includes a preceding guide roller 37 disposed adjacent to the immediately preceding guide roller 36. The preceding guide roller 37 is disposed downstream of the supply reel 26. Thus, the polishing tape T extends from the supply reel 26, passing through the preceding guide roller 37, the immediately preceding guide roller 36, the immediately following guide roller 38, and the tape feed mechanism 30 in this order, to the take-up reel 27.

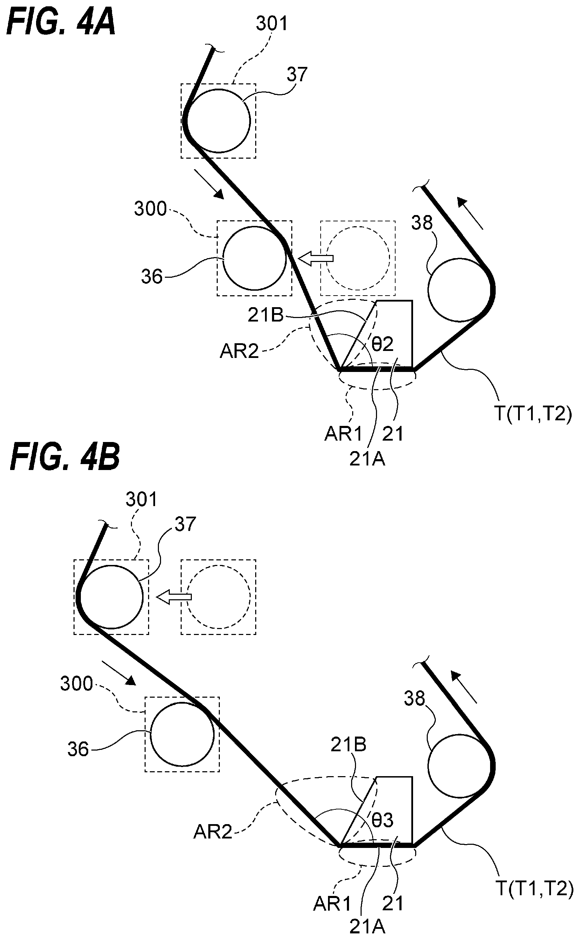

FIGS. 4A and 4B are views showing a preceding guide roller actuator that moves the preceding guide roller. The polishing head 22 may include a preceding guide roller actuator 301 that moves the preceding guide roller 37.

The preceding guide roller actuator 301 may have the same structure as the immediately preceding guide roller actuator 300. An example of the preceding guide roller actuator 301 is a combination of a ball screw mechanism and a servo motor. For example, the preceding guide roller 37 is coupled to a ball screw mechanism (not shown) and configured to be movable by driving of a servo motor (not shown).

The operation controller 10 is electrically connected to the preceding guide roller actuator 301, and is configured to control an operation of the preceding guide roller actuator 301. The operation controller 10 operates the preceding guide roller actuator 301 to move the preceding guide roller 37 in the horizontal direction.

After the immediately preceding guide roller actuator 300 operates the immediately preceding guide roller 36 to determine the tape angle to the second angle θ2 (see FIG. 4A), the preceding guide roller actuator 301 moves the preceding guide roller 37 in the moving away direction (see FIG. 4B). At this time, the immediately preceding guide roller actuator 300 operates the immediately preceding guide roller 36 to a position where the immediately preceding guide roller 36 does not contact the polishing tape T.

In this manner, the preceding guide roller 37 moves the polishing tape T to determine the tape angle to a third angle θ3, which is greater than the second angle θ2. The third angle θ3 is an obtuse angle, and is greater than the second angle θ2. In this manner, the preceding guide roller actuator 301 may move the preceding guide roller 37 in the moving away direction until the tape angle becomes the third angle θ3.

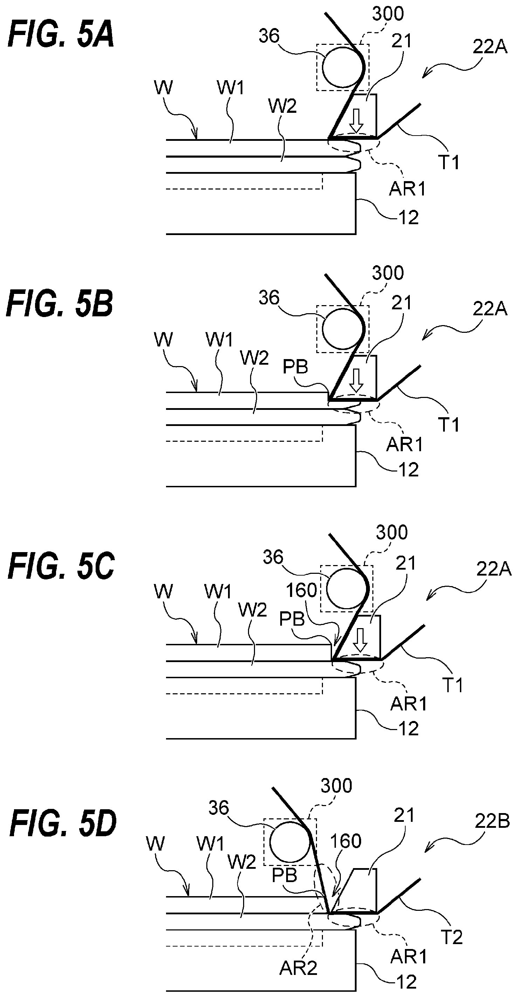

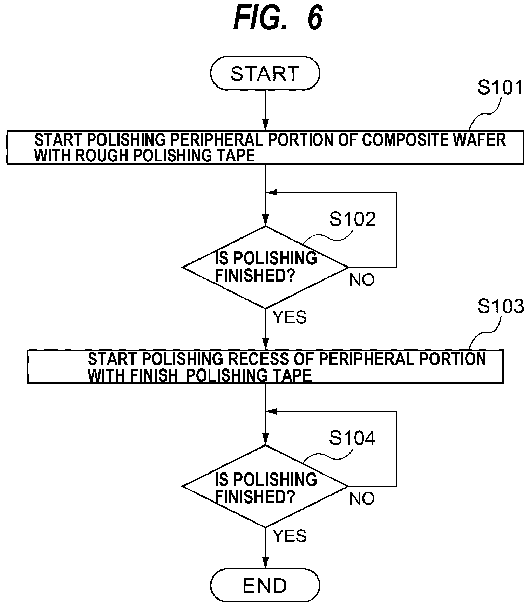

FIGS. 5A to 5D are views showing steps of polishing the first wafer. FIG. 6 is a view showing a flow of polishing the first wafer by the polishing apparatus. The first wafer W1 is polished as follows.

First, the composite wafer W is placed on the substrate holding surface 12a by a transfer device (not shown) so that the center of the composite wafer W coincides with the axis CL of the substrate holding surface 12a. When the operation controller 10 drives the stage rotation device 15, the stage rotation device 15 rotates the holding stage 12 about the axis CL, and the composite wafer W rotates together with the holding stage 12.

The liquid supply nozzle 18 supplies the liquid to the center of the first wafer W1 to form a film of the liquid on the upper surface of the first wafer W1. When the operation controller 10 drives the moving actuator 23, the moving actuator 23 moves the entire polishing head 22A including the pressing member 21 toward the first wafer W1.

The pressing member 21 presses the polishing surface of the rough polishing tape T1 against the peripheral portion of the first wafer W1 (see FIG. 5A and step S101 in FIG. 6). More specifically, the pressing member 21 presses the rough polishing tape T1 in the area AR1 against the peripheral portion of the first wafer W1.

At this time, the operation controller 10 polishes the peripheral portion of the first wafer W1 by moving the pressing member 21 in a depth direction of the composite wafer W with the tape angle determined to the first angle θ1 by the immediately preceding guide roller actuator 300. A direction in which the pressing member 21 presses the rough polishing tape T1 against the peripheral portion of the first wafer W1 is perpendicular to the upper surface of the first wafer W1, which corresponds to the depth direction of the composite wafer W (see FIG. 5B).

The peripheral portion of the first wafer W1 is polished by a relative motion between the rough polishing tape T1 and the first wafer W1 in a presence of the liquid. During polishing of the first wafer W1, the rough polishing tape T1 is fed in its conveying direction (i.e., a longitudinal direction) at a predetermined speed.

During polishing of the first wafer W1, the displacement sensor 33 detects a signal corresponding to the moving distance of the pressing member 21. The operation controller 10 measures the moving distance of the pressing member 21 based on the signal sent from the displacement sensor 33. The operation controller 10 determines the polishing end point, which is a time point when the moving distance of the pressing member 21 reaches a preset target value. In other words, the operation controller 10 determines whether polishing of the first wafer W1 has been finished based on the signal obtained from the displacement sensor 33 (see step S102 in FIG. 6).

If the operation controller 10 determines that polishing of the first wafer W1 has not been completed (see "NO" in step S102), the operation controller 10 continues polishing of the first wafer W1. On the other hand, if the operation controller 10 determines that polishing of the first wafer W1 has been finished (see "YES" in step S102), the operation controller 10 finishes polishing of the first wafer W1. In this manner, the polishing head 22A forms a recess 160 having a predetermined depth in the peripheral portion of the composite wafer W (see FIG. 5C).

In this embodiment, the operation controller 10 determines the polishing end point of the first wafer W1 based on a signal sent from the displacement sensor 33, but in one embodiment, the operation controller 10 may determine the polishing end point of the first wafer W1 based on a polishing time. In this case, the operation controller 10 determines the finishing of polishing of the first wafer W1 when a predetermined polishing time has elapsed.

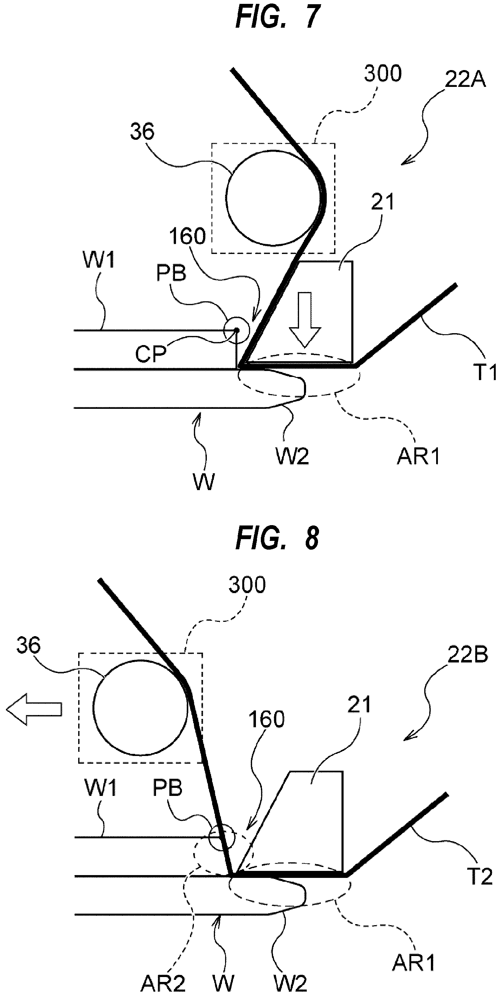

FIG. 7 is a view showing the polishing boundary of the recess. As shown in FIG. 7, when the recess 160 is formed on the peripheral portion of the composite wafer W, a chipping CH, which is called chipping, may occur at the polishing boundary PB of the recess 160. The polishing boundary PB is defined as a boundary between a polished area of the first wafer W1 polished by the polishing head 22A and an unpolished area of the first wafer W1 that has not been polished.

After determining the polishing end point, the operation controller 10 operates the moving actuator 23 of the polishing head 22A to move the polishing head 22A including the pressing member 21 in a direction away from the first wafer W1. Thereafter, the operation controller 10 operates the moving actuator 23 of the polishing head 22B to move the entire polishing head 22B including the pressing member 21 toward the first wafer W1.

At this time, the operation controller 10 operates the immediately preceding guide roller actuator 300 to press the finish polishing tape T2 against the polishing boundary PB of the recess 160 in a state in which the tape angle is determined to be the second angle θ2 (see FIG. 5D and step S103 in FIG. 6). More specifically, the polishing head 22B presses the finish polishing tape T2 in the area AR2 against the polishing boundary PB.

The operation controller 10 may move the polishing head 22B to a predetermined polishing position adjacent to the recess 160, and then operate the immediately preceding guide roller actuator 300 to determine the tape angle to the second angle θ2, or may move the polishing head 22B to the predetermined polishing position after determining the tape angle to the second angle θ2.

FIG. 8 is a view showing a polishing head that removes the chipping with the polishing tape. As shown in FIG. 8, the polishing head 22B is configured to remove the chipping CH by pressing the finish polishing tape T2 against the chipping CH formed in the polishing boundary PB. In particular, by removing the chipping CH with the finish polishing tape T2 in the area AR2, it is possible to prevent the finish polishing tape T2 from being cut.

When the finish polishing tape T2 is moved in the depth direction of the composite wafer W and pressed against the chipping CH in the area AR1, the finish polishing tape T2 may come into contact with the chipping CH at a corner of the polishing boundary PB and be cut. In other words, the finish polishing tape T2 in the area AR1 may be sandwiched between the pressing surface 21A of the pressing member 21 and the chipping CH of the polishing boundary PB and be cut.

In this embodiment, by pressing the finish polishing tape T2 in the area AR2 against the chipping CH, the finish polishing tape T2 is elastically deformed toward the inclined surface 21B of the pressing member 21.

More specifically, by pressing the finish polishing tape T2 against the chipping CH with the tape angle set to the second angle θ2, a gap is formed between the finish polishing tape T2 in the area AR2 and the inclined surface 21B of the pressing member 21. Therefore, the finish polishing tape T2 can elastically deform toward the inclined surface 21B. With this configuration, the polishing head 22B can prevent the finish polishing tape T2 from being cut.

After step S103 in FIG. 6, the operation controller 10 determines whether polishing of the first wafer W1 is finished based on the polishing time (i.e., the chipping removal time) required to remove the chipping CH (see step S104 in FIG. 6).

When the operation controller 10 determines that the chipping removal time has not elapsed (see "NO" in step S104 in FIG. 6), the operation controller 10 continues removing the chipping CH. On the other hand, when the operation controller 10 determines that the chipping removal time has elapsed (see "YES" in step S104 in FIG. 6), the operation controller 10 determines to finish the removal of the chipping CH.

In one embodiment, the operation controller 10 may operate the preceding guide roller actuator 301 to determine the tape angle to the third angle θ3 and additionally remove the chipping CH. For example, when the chipping CH in the polishing boundary PB is formed over a wide range in the radial direction of the composite wafer W, the operation controller 10 can reliably remove the chipping CH formed over a wide range by moving the preceding guide roller 37 in the moving away direction by the preceding guide roller actuator 301 until the tape angle becomes the third angle θ3.

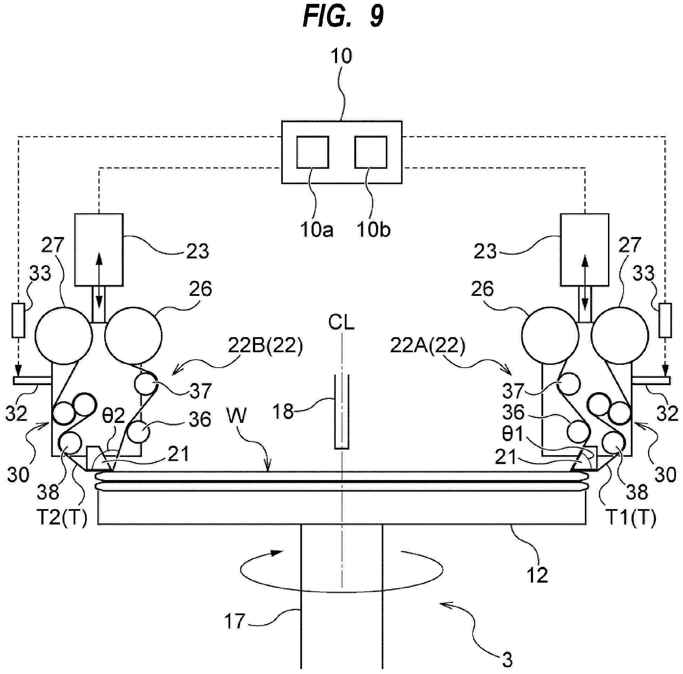

FIG. 9 is a view showing another embodiment of the polishing apparatus. In the above-described embodiment, the polishing heads 22A and 22B have the same configuration, but in the embodiment shown in FIG. 9, the polishing heads 22A and 22B have different configurations.

As shown in FIG. 9, the polishing head 22A is configured to support the rough polishing tape T1 so that the tape angle is the first angle θ1, and the polishing head 22B is configured to support the finish polishing tape T2 so that the tape angle is a second angle θ2.

In this case, there is no need to change the tape angle between the first angle θ1 and the second angle θ2. Therefore, in the embodiment shown in FIG. 9, neither of the polishing heads 22A, 22B includes the immediately preceding guide roller actuator 300 (and the preceding guide roller actuator 301).

In this manner, as long as the polishing apparatus includes the polishing head 22A that forms the recess 160 on the peripheral portion of the composite wafer W, and the polishing head 22B that removes the chipping CH formed in the recess 160, the polishing heads 22A and 22B do not necessarily need to include the immediately preceding guide roller actuator 300 (and the preceding guide roller actuator 301).

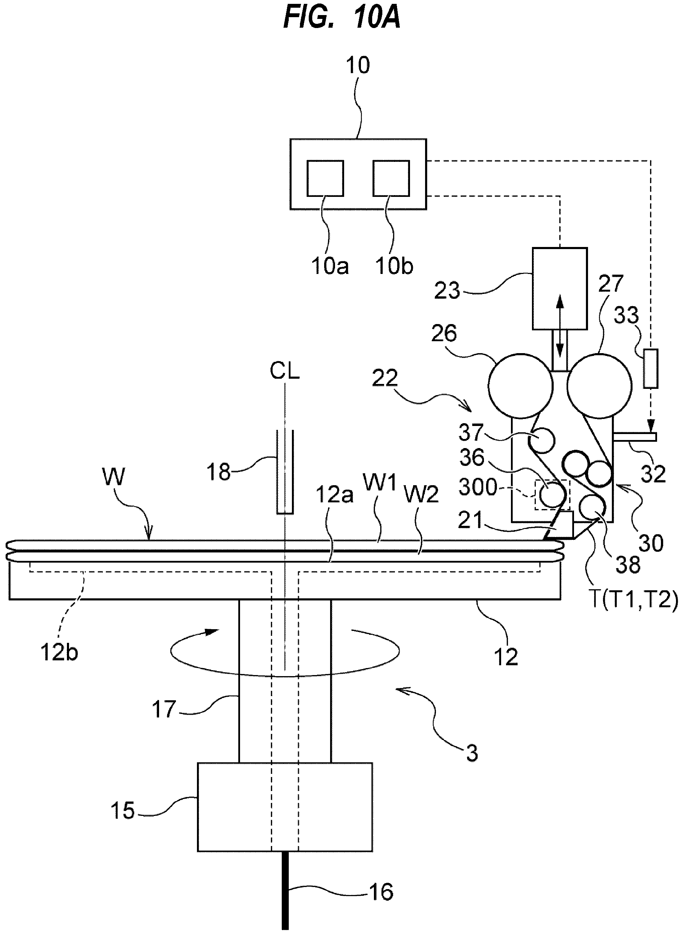

FIG. 10A is a view showing another embodiment of the polishing apparatus. In the above-described embodiment, the polishing apparatus includes a plurality of polishing heads 22A and 22B. However, as shown in FIG. 10A, the polishing apparatus may include a single polishing head 22.

In the above-described embodiment, the polishing head 22A supports the rough polishing tape T1 for forming the recess 160 on the peripheral portion of the composite wafer W, and the polishing head 22B supports the finish polishing tape T2 for removing the chipping CH formed in the recess 160.

However, depending on polishing conditions such as a type (e.g., hardness) of the composite wafer W to be polished, the polishing apparatus does not necessarily have to include the polishing heads 22A, 22B that separately support the two types of polishing tapes T1, T2, and may include a single polishing head 22. In this case, the polishing apparatus is configured to operate the polishing head 22 to form the recess 160 on the peripheral portion of the composite wafer W and to remove the chipping CH formed in the recess 160.

The polishing head 22 in the embodiment shown in FIG. 10A has the same structure as the polishing heads 22A and 22B described with reference to FIG. 1 to FIG. 8. Therefore, the polishing head 22 includes the pressing member 21, the preceding guide roller 36, and the immediately preceding guide roller actuator 300. In one embodiment, the polishing head 22 may further include the preceding guide roller actuator 301 that moves the preceding guide roller 37 (see FIG. 4B).

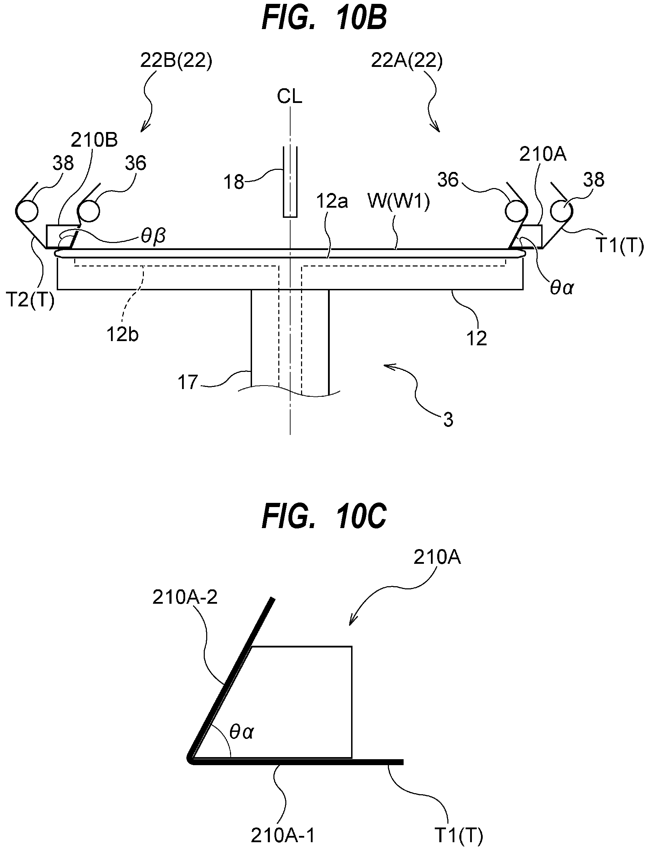

FIG. 10B is a view showing another embodiment of the polishing apparatus. As shown in FIG. 10B, the polishing apparatus may be configured to polish a single wafer W rather than the composite wafer W. In one embodiment, the polishing apparatus may be configured to polish the composite wafer W in the embodiment shown in FIG. 10B, as in the embodiment described above. In the embodiments shown in FIGS. 2 to 10A, the polishing apparatus may be configured to polish the single wafer W rather than the composite wafer W.

In the embodiment shown in FIG. 10B, the polishing apparatus includes pressing members 210A and 210B having different shapes. Specifically, the polishing head 22A includes the pressing member 210A having a first angle θα as an acute angle. The polishing head 22B includes the pressing member 210B having a second angle θβ as an obtuse angle. In the embodiment shown in FIG. 10B, the second angle θβ is an obtuse angle, but may be a right angle. Hereinafter, in this specification, the pressing members 210A and 210B may be simply referred to as a pressing member 210 without any particular distinction.

FIG. 10C is a view showing the pressing member having the first angle. As shown in FIG 10C, the pressing member 210A has a pressing surface 210A-1 parallel to the substrate holding surface 12a and an inclined surface 210A-2 connected to the pressing surface 210A-1.

The first angle θα is the angle between the pressing surface 210A-1 and the inclined surface 210A-2. The polishing head 22A positions the polishing tape T so as to be along the pressing surface 210A-1 and the inclined surface 210A-2, thereby determining the tape angle to be the first angle θα.

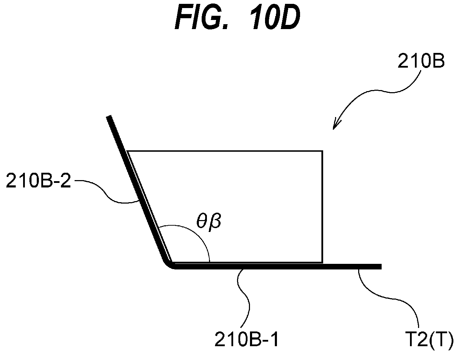

FIG. 10D is a view showing a pressing member having a second angle. As shown in FIG 10D, the pressing member 210B has a pressing surface 210B-1 parallel to the substrate holding surface 12a and an inclined surface 210B-2 connected to the pressing surface 210B-1.

The second angle θβ is the angle between the pressing surface 210B-1 and the inclined surface 210B-2. The polishing head 22B positions the polishing tape T so as to be along the pressing surface 210B-1 and the inclined surface 210B-2, thereby determining the tape angle to be the second angle θβ.

With this configuration, the polishing head 22 does not need to change the tape angle between the first angle θα and the second angle θβ. Therefore, in the embodiment shown in FIGS. 10B to 10D, neither of the polishing heads 22A and 22B needs to include the immediately preceding guide roller actuator 300 (and the preceding guide roller actuator 301).

In the embodiments shown in FIGS. 2 to 10A, the polishing tool corresponds to the polishing tape T, whereas in the embodiment shown in FIGS. 10B to 10D, the polishing tool corresponds to a combination of the polishing tape T and the pressing member 210. Specifically, the polishing tool having the first angle θα corresponds to a combination of the polishing tape T and the pressing member 210A, and the polishing tool having the second angle θβ corresponds to a combination of the polishing tape T and the pressing member 210B.

In this manner, in the above-described embodiment (see FIGS. 1 to 10D), the polishing head 22A is configured to hold a polishing tool (polishing tape T, or a combination of the polishing tape T and the pressing member 210) having the first angle as the acute angle, and is configured to press such a polishing tool against the peripheral portion of the wafer W (the single wafer W or the composite wafer W) to form the recess in the peripheral portion. The polishing head 22B is configured to hold a polishing tool (polishing tape T) having the second angle as the right angle or the obtuse angle, and is configured to press such a polishing tool against the polishing boundary PB of the recess.

In one embodiment, each of the polishing heads 22A and 22B may hold a grindstone instead of a grinding tape as a grinding tool. With such a configuration, the polishing apparatus can also remove the chipping. Hereinafter, the configuration of the polishing apparatus including the polishing head that hold the grindstone will be described with reference to the drawings.

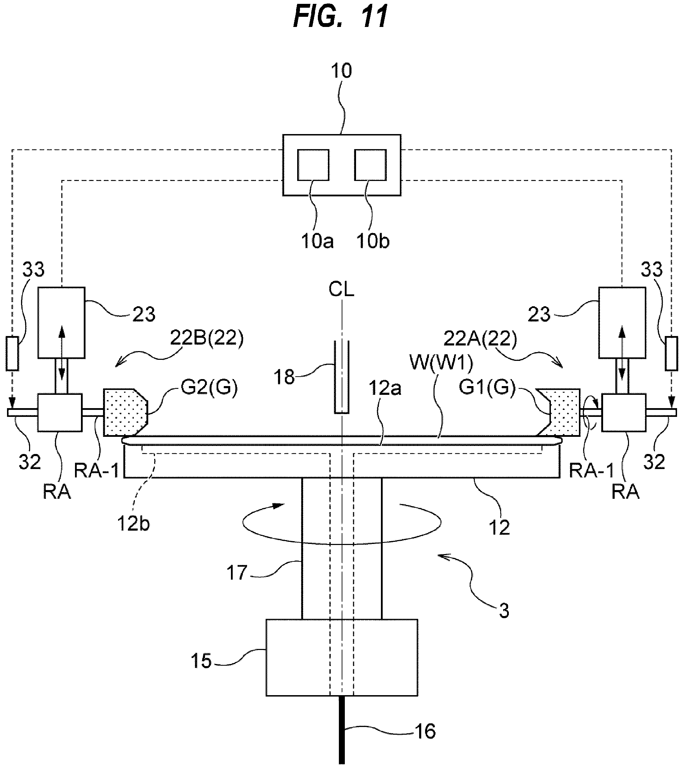

FIG. 11 is a view showing another embodiment of the polishing apparatus. In the embodiment shown in FIG. 11, the polishing apparatus is configured to polish the single wafer W, but may also be configured to polish the composite wafer W.

As shown in FIG. 11, the polishing head 22A is configured to hold a grindstone G1 as a polishing tool having the first angle as an acute angle. The polishing head 22B is configured to hold a grindstone G2 as a polishing tool having a second angle as a right angle or an obtuse angle. Hereinafter, the grindstone G1 and the grindstone G2 may be simply referred to as a grindstone G without any particular distinction.

Each of the polishing heads 22A and 22B includes a drive actuator RA that holds the grindstone G and rotates the grindstone G. The drive actuator RA is, for example, a motor, and is held by the moving actuator 23.

The drive actuator RA has a rotation axis RA-1 to which the grindstone G is fixed. When the drive actuator RA is driven, the grindstone G rotates about the rotation axis RA-1. By driving the moving actuator 23, the drive actuator RA and the grindstone G are lowered in the depth direction of the wafer W at the peripheral portion of the wafer W. By driving the drive actuator RA, the grindstone G comes into contact with the peripheral portion of the wafer W while rotating, and polishes (cuts, grinds) the peripheral portion of the wafer W.

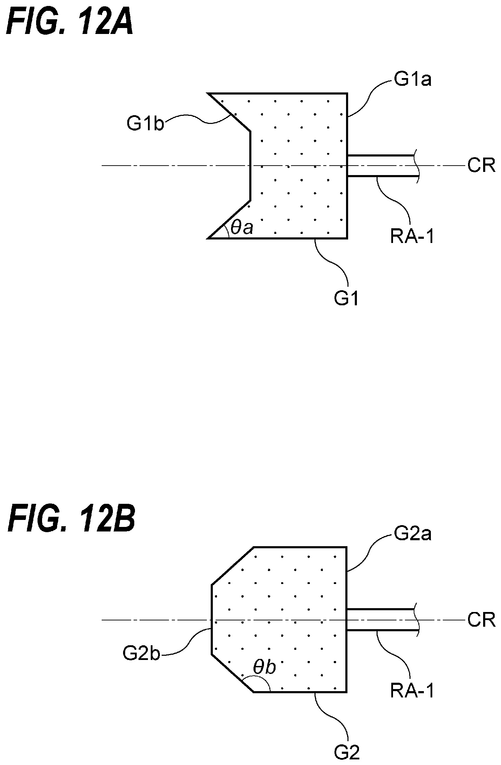

FIG. 12A is a view showing a grindstone having a tapered recess, and FIG. 12B is a view showing a grindstone having a tapered protrusion. As shown in FIG. 12A, the grindstone G1 has a main body G1a fixed to the rotation axis RA-1 and a tapered recess G1b connected to the main body G1a. The main body G1a and the tapered recess G1b are integrally molded members.

The tapered recess G1b has a tapered shape that extends toward a central axis CR of the rotation axis RA-1 and close to the main body G1a, and has a first angle θa as an acute angle. In FIG. 12A, the tapered recess G1b has a cone shape with a flat portion, but the tapered recess G1b may have a cone shape without a flat portion as long as the first angle θa can be formed.

As shown in FIG. 12B, the grindstone G2 has a main body G2a fixed to the rotation axis RA-1 and a tapered protrusion G2b connected to the main body G2a. The main body G2a and the tapered protrusion G2b are integrally molded members.

The tapered protrusion G2b has a tapered shape that extends toward the central axis CR of the rotation axis RA-1 and away from the main body G2a, and has a second angle θb as an obtuse angle. The second angle θb may be a right angle. In FIG. 12B, the tapered protrusion G2b has a truncated cone shape, but the tapered protrusion G2b may have a cone shape as long as the second angle θb can be formed.

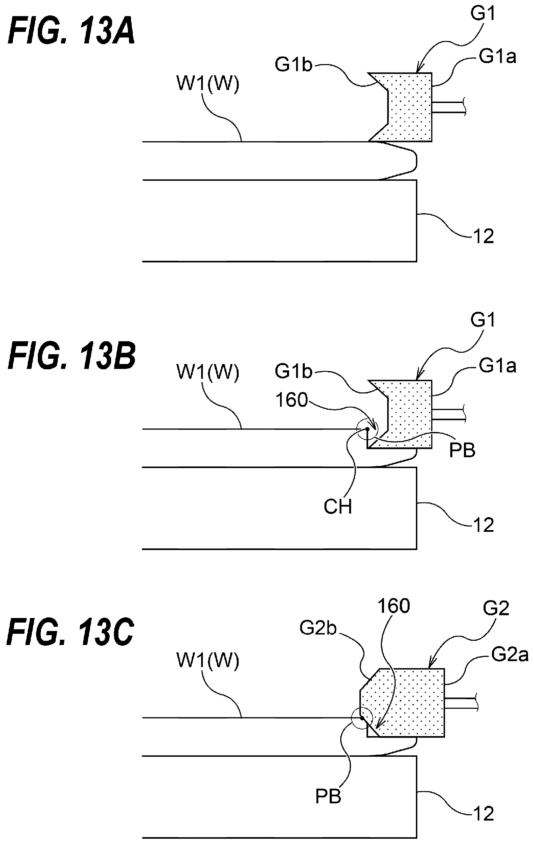

FIGS. 13A to 13C are views showing a process of polishing the peripheral portion of the wafer. As shown in FIG. 13A, the operation controller 10 (see FIG. 11) drives the moving actuator 23 to lower the grindstone G1 (and the drive actuator RA) and press the grindstone G1 against the peripheral portion of the wafer W. At this time, the grindstone G1 is rotated by the drive actuator RA of the polishing head 22A.

The polishing head 22A continues polishing the peripheral portion of the wafer W with the grindstone G1, and forms the recess 160 having a predetermined depth in the peripheral portion of the wafer W (see FIG. 13B). Thereafter, the operation controller 10 drives the moving actuator 23 to move the grindstone G1 away from the peripheral portion of the wafer W.

Furthermore, the operation controller 10 drives the moving actuator 23 to press the grindstone G2 against the polishing boundary PB of the recess 160 (see FIG. 13C). At this time, the grindstone G2 is rotated by the drive actuator RA of the polishing head 22B. The polishing head 22B can remove the chipping CH by pressing the grindstone G2 against the chipping CH formed in the polishing boundary PB.

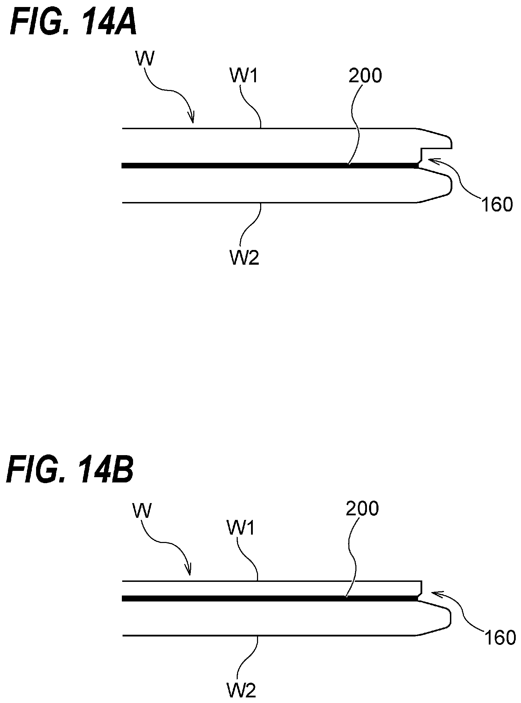

FIGS. 14A and 14B are views showing a manufacturing process of the composite wafer. As shown in FIG. 14A, the first wafer W1 has the recess 160 where the chipping CH has been removed. The first wafer W1 is bonded to the second wafer W2 to manufacture the composite wafer W.

When the first wafer W1 is bonded to the second wafer W2, the device layer 200 formed on the first wafer W1 faces the second wafer W2. Then, the back surface (i.e., the surface on which the device layer 200 is not formed) of the first wafer W1 is polished by a predetermined amount (see FIG. 14B).

As shown in the above-described embodiment, the polishing apparatus includes the first polishing head 22A that holds a first polishing tool (polishing tape or grindstone) having a first angle as an acute angle, and the second polishing head 22B that holds a second polishing tool (polishing tape or grindstone) having a second angle as a right angle or an obtuse angle. Therefore, the polishing apparatus can form the recess 160 on the peripheral portion of the wafer W (the single wafer W or the composite wafer W) and further remove the chipping CH formed on the polishing boundary PB of the recess 160.

The above-described embodiments may be appropriately combined. For example, the polishing apparatus may include a polishing head that holds a polishing tape and a polishing head that holds a grindstone. With such a configuration, the polishing apparatus can also remove the chipping CH.

For example, the polishing apparatus may include a polishing head 22A according to the embodiment shown in FIG. 11 and a polishing head 22B according to the embodiment shown in FIGS. 2 to 9 (or FIG. 10B). In this case, the polishing head 22A holds the grindstone G1 as a polishing tool. The polishing head 22B holds the polishing tape T2 (or a combination of the polishing tape T2 and the pressing member 210B) as a polishing tool.

The grindstone G1 can polish the wafer W faster than the polishing tape T1, and therefore the polishing time can be shortened. In this case, when the wafer W is polished by the grindstone G1 held by the polishing head 22A, the surface of the recess 160 becomes rough after polishing is finished.

Therefore, by finish-polishing the recess 160 of the wafer W with the polishing tape T2 (or a combination of the polishing tape T2 and the pressing member 210B) held by the polishing head 22B, it is possible to increase a flatness of the surface of the recess 160. In other words, with such a configuration, the polishing apparatus can shorten the polishing time and improve the flatness of the surface of the recess 160.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

## Claims

1. A polishing apparatus comprising:
a first polishing head configured to hold a first polishing tool having a first angle as an acute angle; and
a second polishing head configured to hold a second polishing tool having a second angle as a right angle or an obtuse angle, and
wherein the first polishing head is configured to press the first polishing tool against a peripheral portion of a substrate to form a recess in the peripheral portion, and
wherein the second polishing head is configured to press the second polishing tool against a polishing boundary of the recess.

2. The polishing apparatus according to claim 1,
wherein the first polishing head corresponds to a rough polishing head configured to press a rough polishing tape as the first polishing tool against the peripheral portion to form a recess in the peripheral portion,
wherein the second polishing head corresponds to a finish polishing head configured to press a finish polishing tape as the second polishing tool against the polishing boundary,
wherein the rough polishing head is configured to support the rough polishing tape so that a tape angle of the rough polishing tape is the first angle, and
wherein the finish polishing head is configured to support the finish polishing tape so that a tape angle of the finish polishing tape is the second angle.

3. The polishing apparatus according to claim 2,
wherein each of the rough polishing head and the finish polishing head comprises:
a pressing member for pressing each of the rough polishing tape and the finish polishing tape against the peripheral portion,
an immediately preceding guide roller disposed upstream of the pressing member in a conveying direction of each of the rough polishing tape and the finish polishing tape, and disposed adjacent to the pressing member, and
an immediately preceding guide roller actuator configured to move the immediately preceding guide roller.

4. The polishing apparatus according to claim 3,
wherein the immediately preceding guide roller actuator is configured to move the immediately preceding guide roller in a direction approaching the pressing member and in a direction away from the pressing member.

5. The polishing apparatus according to claim 3,
wherein the polishing apparatus comprises an operation controller configured to control an operation of the immediately preceding guide roller actuator, and
wherein the operation controller is configured to:
operate the immediately preceding guide roller actuator to move the immediately preceding guide roller until the tape angle of the rough polishing tape becomes the first angle; and
operate the immediately preceding guide roller actuator to move the immediately preceding guide roller until the tape angle of the finish polishing tape becomes the second angle.

6. The polishing apparatus according to claim 5,
wherein the operation controller is configured to:
operate the immediately preceding guide roller actuator to move the rough polishing tape in a depth direction of the substrate while the tape angle is at the first angle, forming the recess having a predetermined depth in the peripheral portion; and
operate the immediately preceding guide roller actuator to set the tape angle to the second angle and press the finish polishing tape against the polishing boundary.

7. The polishing apparatus according to claim 6,
wherein the operation controller is configured to operate the immediately preceding guide roller actuator to press the finish polishing tape in an area located between the immediately preceding guide roller and the pressing member against the polishing boundary.

8. The polishing apparatus according to claim 3,
wherein each of the rough polishing head and the finish polishing head comprises:
a preceding guide roller disposed upstream of the immediately preceding guide roller in the conveying direction of each of the rough polishing tape and the finish polishing tape, and disposed adjacent to the immediately preceding guide roller; and
a preceding guide roller actuator configured to move the preceding guide roller, and
wherein the preceding guide roller actuator is configured to move the preceding guide roller until the preceding guide roller reaches a third angle greater than the second angle.

9. The polishing apparatus according to claim 8,
wherein the polishing apparatus comprises an operation controller configured to control an operation of the preceding guide roller actuator, and
wherein the operation controller is configured to operate the immediately preceding guide roller actuator to press the finish polishing tape against the polishing boundary, and operate the preceding guide roller actuator to move the preceding guide roller until the tape angle becomes the third angle.

10. The polishing apparatus according to claim 1,
wherein the first polishing head is configured to hold a first grindstone as the first polishing tool,
wherein the second polishing head is configured to hold a second grindstone as the second polishing tool,
wherein the first grindstone has a tapered recess configured to form the first angle, and
wherein the second grindstone has a tapered protrusion configured to form the second angle.

11. A polishing method comprising:
pressing a first polishing tool having a first angle as an acute angle against a peripheral portion of a substrate by a first polishing head to form a recess in the peripheral portion; and
pressing a second polishing tool having a second angle as a right angle or obtuse angle against a polishing boundary of the recess by a second polishing head.

12. The polishing method according to claim 11,
wherein the first polishing head corresponds to a rough polishing head configured to press a rough polishing tape as the first polishing tool against the peripheral portion to form a recess in the peripheral portion,
wherein the second polishing head corresponds to a finish polishing head configured to press a finish polishing tape as the second polishing tool against the polishing boundary, and
wherein the polishing method comprising:
setting a tape angle of the rough polishing tape to the first angle, and pressing the rough polishing tape against the peripheral portion to form the recess in the peripheral portion; and
setting a tape angle of the finish polishing tape to the second angle, and pressing the finish polishing tape against the polishing boundary.

13. The polishing method according to claim 12, comprising:
operating an immediately preceding guide roller disposed upstream of a pressing member in a conveying direction of each of the rough polishing tape and the finish polishing tape and disposed adjacent to the pressing member to set the tape angle to the first angle; and
operating the immediately preceding guide roller to set the tape angle to the second angle.

14. The polishing method according to claim 13,
comprising operating a preceding guide roller disposed upstream of the immediately preceding guide roller in the conveying direction of each of the rough polishing tape and the finish polishing tape and disposed adjacent to the immediately preceding guide roller to set the tape angle to a third angle greater than the second angle.

15. The polishing method according to claim 11,
wherein the first polishing head is configured to hold a first grindstone as the first polishing tool,
wherein the second polishing head is configured to hold a second grindstone as the second polishing tool, and
the polishing method comprising:
pressing the first grindstone having a tapered recess configure to form the first angle against the peripheral portion to form the recess in the peripheral portion; and
pressing the second grindstone having a tapered protrusion configured to form the second angle against the polishing boundary.

16. A polishing head comprising:
a pressing member for pressing a polishing tape against a peripheral portion;
an immediately preceding guide roller disposed upstream of the pressing member in a conveying direction of the polishing tape and disposed adjacent to the pressing member; and
an immediately preceding guide roller actuator configured to move the immediately preceding guide roller, and
wherein the immediately preceding guide roller actuator is configured to:
move the immediately preceding guide roller until a tape angle of the polishing tape becomes a first angle as an acute angle; and
move the immediately preceding guide roller until the tape angle becomes a second angle as a right angle or an obtuse angle.

17. The polishing head according to claim 16,
wherein the immediately preceding guide roller actuator is configured to move the immediately preceding guide roller in a direction approaching the pressing member and in a direction away from the pressing member.

18. The polishing head according to claim 16,
wherein the polishing head is configured to:
move the polishing tape in a depth direction of the substrate to form a recess having a predetermined depth in the peripheral portion while setting the tape angle to the first angle by the immediately preceding guide roller actuator; and
press the polishing tape against a polishing boundary of the recess while setting the tape angle to a second angle by the immediately preceding guide roller actuator.

19. The polishing head according to claim 16,
wherein the polishing head comprises:
a preceding guide roller disposed upstream of the immediately preceding guide roller in a conveying direction of the polishing tape and disposed adjacent to the immediately preceding guide roller; and
a preceding guide roller actuator configured to move the preceding guide roller, and
wherein the preceding guide roller actuator is configured to move the preceding guide roller until the tape angle becomes a third angle greater than the second angle.
